# EUROPÄISCHE PATENTSCHRIFT

(11) **EP 1 282 920 B1**
(45) Veröffentlichungstag und Bekanntmachung des Hinweises auf die Patenterteilung: **02.08.2006**
(21) Anmeldenummer: 01929636.7
(22) Anmeldetag: 10.05.2001
(51) Int. Cl.: H01L 41/09

(54) **PIEZO-BIEGEWANDLER UND VERWENDUNG DESSELBEN**
PIEZOELECTRIC FLEXION CONVERTER AND USE THEREOF
TRANSDUCTEUR DE FLEXION PIEZO-ELECTRIQUE ET UTILISATION DE CELUI-CI

(30) Priorität: 15.05.2000 DE 10023310
(43) Veröffentlichungstag der Anmeldung: 12.02.2003
(73) Patentinhaber: FESTO AG & Co, 73734 Esslingen (DE)
(72) Erfinder: SCHMID, Andreas, 96247 Michelau (DE); RIEDEL, Michael, 96472 Rödental (DE); LUBITZ, Karl, 85521 Ottobrunn (DE); MAICHL, Martin, 73084 Salach (DE); HOFFMANN, Markus, 72649 Wolfschlugen (DE); WEINMANN, Michael, 73655 Plüderhausen (DE)
(74) Vertreter: Abel, Martin
(86) Internationale Anmeldenummer: PCT/EP2001/005321
(87) Internationale Veröffentlichungsnummer: WO 2001/089003

(56) Entgegenhaltungen:
- WO-A-98/37343
- WO-A-99/17383
- WO-A-99/25033
- DE-A- 19 742 294
- DE-C- 4 410 153
- US-A- 4 330 730
- US-A- 6 024 340

## Beschreibung

Die Erfindung betrifft einen Piezo-Biegewandler, mit einem länglichen Tragkörper, der an wenigstens einer Längsseite mit einer Piezoeinheit bestückt ist, die einen Piezokörper mit einer oder mehreren Piezomaterialschichten und diesen zugeordneten Elektroden aufweist, wobei die Elektroden elektrisch leitend mit dem Tragkörper verbunden sind. Ferner betrifft die Erfindung eine Verwendung eines derartigen Piezo-Biegewandlers.

Ein aus der WO 99/17383 bekannter Piezo-Biegewandler der vorgenannten Art verfügt über einen länglichen Tragkörper, der an einander entgegengesetzten Längsseiten mit jeweils einer Piezoeinheit bestückt ist. Die Piezoeinheit enthält einen in Multilayer-Technologie aufgebauten Piezokörper mit mehreren Piezomaterialschichten und diesen zugeordneten Elektroden. Durch Anlegen einer Ansteuerspannung an die Elektroden können im Piezokörper elektrische Felder hervorgerufen werden, was eine Längenkontraktion des Piezokörpers nach sich zieht und eine mit einer Schwenkbewegung vergleichbare Auslenkung des Piezo-Biegewandlers bezüglich einer Einspannstelle verursacht. Um die Ansteuerspannung aufbringen zu können, sind die Elektroden einer jeweiligen Piezoeinheit mit dem Tragkörper kontaktiert, der mit einer Spannungsquelle verbindbar ist.

Beim Betrieb des bekannten Biegewandlers können durch Feuchtigkeit bedingte Probleme auftreten. Wird der Piezo-Biegewandler beispielsweise als Stellglied eines zur Steuerung eines Fluides dienenden Ventils eingesetzt, wobei er ständig von Feuchtigkeit enthaltendem Medium umströmt ist, können partiell Kurzschlüsse auftreten, die das Auslenkungsverhalten des Piezo-Biegewandlers und die Funktionsfähigkeit der mit dem Piezo-Biegewandler ausgestatteten Einrichtung beeinträchtigen.

Es ist die Aufgabe der vorliegenden Erfindung, einen Piezo-Biegewandler der eingangs genannten Art zu schaffen, der bei einfacher Herstellung gegen äußere Einflüsse und insbesondere gegen Feuchtigkeit unempfindlich ist. Eine weitere Aufgabe besteht in der Angabe einer Verwendung für einen derartigen Piezo-Biegewandler.

Die erstgenannte Aufgabe wird durch einen Piezo-Biegewandler der eingangs genannten Art gelöst, bei dem die Piezoeinheit einen den Piezokörper ringsum umhüllenden, elektrisch isolierenden Überzug aufweist, der mit einer oder mehreren elektrisch leitenden Durchkontaktierungen zur elektrischen Kontaktierung der Elektroden versehen ist.

Auf diese Weise liegt ein Piezo-Biegewandler vor, bei dem der die Elektroden aufweisende Piezokörper durch den ihn umhüllenden, elektrisch isolierenden Überzug komplett gekapselt und zur Umgebung hin abgeschirmt ist. Äußeren Einflüssen ist es daher unmöglich, mit dem Piezokörper und dessen Bestandteilen in Kontakt zu treten, so daß Funktionsbeeinträchtigungen, beispielsweise hervorgerufen durch Feuchtigkeit, ausgeschlossen werden können. Zum Anlegen der Ansteuerspannung ist die Piezoeinheit je nach Ausführungsform mit einer oder mehreren, den Überzug durchsetzenden elektrisch leitenden Durchkontaktierungen versehen.

Zwar wäre es prinzipiell möglich, den gesamten Piezo-Biegewandler mit einem einheitlichen Überzug auszustatten. Die eigenständige Umhüllung der vorhandenen einen oder mehreren Piezoeinheiten unabhängig vom Tragkörper hat jedoch sowohl fertigungstechnisch als auch hinsichtlich der Kosten nicht unwesentliche Vorteile. Die Durchkontaktierungen können die elektrisch leitende Verbindung zwischen den Elektroden des Piezomaterials und den Leitern des Tragkörpers herstellen oder zu Elektroden an den sonstigen Außenseiten des Piezomaterials führen.

Vorteilhafte Weiterbildungen der Erfindung gehen aus den Unteransprüchen hervor.

Zweckmäßigerweise befinden sich die Durchkontaktierungen in dem dem Tragkörper zugewandten Abschnitt des Überzuges, so daß beim Anbringen einer Piezoeinheit am Tragkörper gleichzeitig die elektrische Kontaktierung zwischen einer jeweiligen Piezoeinheit und dem Tragkörper stattfinden kann. Außerdem lässt sich durch die in der Regel zwischen der Piezoeinheit und dem Tragkörper vorhandene, zur Fixierung der Piezoeinheit dienende Klebeschicht der Umgebungsbereich der Durchkontaktierungen zuverlässig zur Umgebung hin abdichten.

Im Bereich einer jeweiligen Durchkontaktierung verfügt der Tragkörper zweckmäßigerweise über eine mit der Durchkontaktierung verbundene, elektrisch leitende Kontaktfläche. Es ist ferner von Vorteil, wenn jeder Durchkontaktierung eine an der dem Tragkörper zugewandten Außenfläche des am Tragkörper anliegenden Abschnittes des Überzuges vorgesehene Kontaktierungsschicht zugeordnet ist, die zur Kontaktierung des Tragkörpers dient. Sie kann mit ausreichend großem Umriss bemessen werden, so daß ohne großen Justieraufwand beim Ansetzen der Piezoeinheit eine sichere und zuverlässige Kontaktierung gewährleistet werden kann.

Der erfindungsgemäße Aufbau ist bereits dann von Vorteil, wenn der Piezokörper über lediglich eine Piezomaterialschicht verfügt, also als monolithischer Piezokörper ausgeführt ist. Aufgrund der vorhandenen Vielzahl von Elektroden erweist sich der Aufbau jedoch bei einem Multilayer-Piezokörper mit einer Mehrzahl von Piezomaterialschichten als besonders empfehlenswert.

Als Werkstoff für den elektrisch isolierenden Überzug wird zweckmäßigerweise ein Parylene (Gruppenbezeichnung für thermoplastische Polymerfilme, die aus p-Xylol gebildet werden) oder ein Polyimid (Sammelbezeichnung für hochtemperaturbeständige Kunststoffe, welche im allgemeinen aromatische Gruppen beinhalten) verwendet.

Die Durchkontaktierungen können an sich beliebig ausgebildet sein. Bei einer besonders einfachen Realisierungsform werden im Überzug bei dessen Herstellung Durchgangslöcher ausgespart, die dann mit leitfähigem Material, beispielsweise Leitkleber, befüllt werden.

Prinzipiell kann auch der Tragkörper mit einem eigenen Überzug versehen werden. Da in Gestalt der Piezokörper jedoch die relevanten Komponenten bereits gekapselt sind, ist auch eine überzugslose Ausgestaltung des Tragkörpers ohne weiteres möglich.

Der Piezo-Biegewandler kann als Unimorph-Biegewandler mit nur einem Piezokörper oder auch als Trimorph-Biegewandler mit zwei an einander entgegengesetzten Längsseiten vorgesehenen gekapselten Piezokörpern ausgestattet sein.

Zur Lösung der oben genannten weiteren Aufgabe ist eine Verwendung des Piezo-Biegewandlers als Stellglied mit Antriebs-oder Abdichtfunktion vorgesehen, beispielsweise im Zusammenhang mit einem zur Fluidsteuerung dienenden Ventil. Die Außenfläche des Überzuges kann hier unmittelbar als Beaufschlagungsfläche und/oder als Dichtfläche herangezogen werden und in diesem Zusammenhang aus Material mit dem gewünschten Reibungskoeffizienten und/oder Dichtverhalten bestehen.

Nachfolgend wird die Erfindung anhand der beiliegenden Zeichnung näher erläutert. In dieser zeigen:
- Figur 1: einen Längsschnitt durch ein bevorzugten Ausführungsbeispiel des erfindungsgemäßen Piezo-Biegewandlers in stark vergrößerter Darstellung gemäß Schnittlinie I-I aus Figur 2, und
- Figur 2: eine Draufsicht auf den Piezo-Biegewandler aus Figur 1, teilweise im Längsschnitt gemäß Schnittlinie II-II.

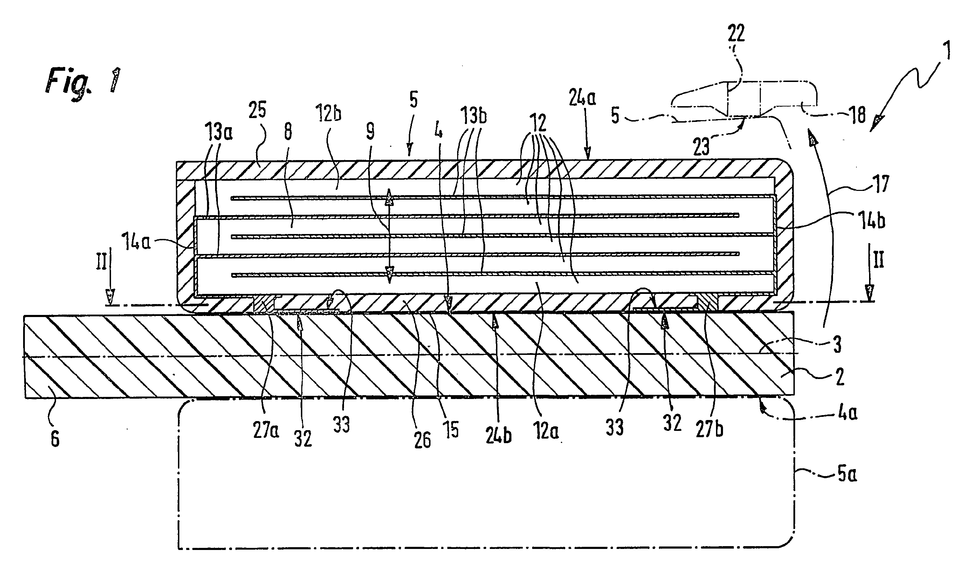

Der in Figur 1 allgemein mit Bezugsziffer 1 bezeichnete Piezo-Biegewandler verfügt über einen plattenartigen, länglichen und Flachgestalt aufweisenden Tragkörper 2 mit ein- oder mehrschichtigem Aufbau. Abgebildet ist ein Einschichtaufbau, also eine Singlelayer-Konstruktion, die vorzugsweise aus einem Faserverbundmaterial besteht, beispielsweise aus kohlefaserverstärktem oder glasfaserverstärktem Epoxidharz. Eine weitere vorzugsweise Ausführung besitzt einen mehrlagigen Aufbau aus Kunststoff, beispielsweise Polyimid. In diesem Material kann eine Elektrodenstruktur enthalten sein.

Ein möglicher Mehrschichtaufbau ist in Figur 1 durch eine strichpunktierte Schichtübergangslinie 3 angedeutet, die gleichzeitig die Ausdehnungsebene des Tragkörpers 2 verdeutlicht.

Eine der beiden längsseitigen großflächigen Außenflächen des Tragkörpers 2 ist als erste Tragfläche 4 ausgebildet, die im vorderen Bereich mit einer ersten Piezoeinheit 5 bestückt ist. Letztere hat ebenfalls eine längliche Gestalt und erstreckt sich parallel zur Längsachse des Tragkörpers 2, wobei sie jedoch zweckmäßigerweise etwas kürzer ist als der Tragkörper 2, so daß dieser rückseitig mit einem Anschlußabschnitt 6 über die erste Piezoeinheit 5 vorsteht.

Der Tragkörper 2 ist mit mehreren sich in seiner Längsrichtung erstreckenden elektrischen Leitern ausgestattet, die nachfolgend zur besseren Verständlichkeit als erste und zweite elektrische Leiter 7a, 7b bezeichnet seien. Sie erstrecken sich ausgehend vom stirnseitigen Endbereich des Anschlussabschnittes 6 in Richtung zur ersten Piezoeinheit 5, die sie dabei untergreifen. Im Bereich des Anschlussabschnittes 6 können die ersten und zweiten elektrischen Leiter 7a, 7b in an sich bekannter Weise an eine Spannungsversorgungsschaltung angeschlossen werden, um die für den Betrieb des Piezo-Biegewandlers 1 erforderliche Ansteuerspannung aufbringen bzw. erzeugen zu können. Die ersten und zweiten elektrischen Leiter 7a, 7b verlaufen beim Ausführungsbeispiel auf der ersten Tragfläche 4.

Die an die erste Tragfläche 4 angesetzte erste Piezoeinheit 5 verfügt über einen länglichen Piezokörper 8, der mehrere in einer zur Ausdehnungsebene 3 rechtwinkeligen Stapelrichtung 9 flächig übereinanderliegend angeordnete Piezomaterialschichten 12 enthält. Das Piezomaterial ist beispielsweise eine geeignete Piezokeramik. Zwischen einander in der Stapelrichtung 9 unmittelbar benachbarten Piezomaterialschichten 12 erstrecken sich abwechselnd erste und zweite Elektroden 13a, 13b mit flächenhafter Ausdehnung. Sie können als Metallisierungsschichten ausgebildet sein, beispielsweise in Form von Silber/Palladium-Metallisierungsschichten. Abgesehen von der dem Tragkörper 2 am nächsten liegenden untersten Piezomaterialschicht 12a und der dieser entgegengesetzten obersten Piezomaterialschicht 12b, die an den vom Schichtkörper abgewandten Seiten elektrodenlos ausgebildet sind, sind somit die Piezomaterialschichten 12 an entgegengesetzten Seiten jeweils von einer ersten und einer zweiten Elektrode 13a, 13b flankiert.

Die ersten und zweiten Elektroden 13a, 13b sind stirnseitig aus den Piezomaterialschichten 12 herausgeführt, wobei sämtliche ersten Elektroden 13a gemeinsam mit ersten elektrischen Kontaktmitteln 14a verknüpft sind, während die zweiten Elektroden 13b gemeinsam mit zweiten elektrischen Kontaktmitteln 14b kontaktiert sind.

Bei montierter erster Piezoeinheit 5 stehen die ersten elektrischen Kontaktmittel 14a und somit die ersten Elektroden 13a mit dem ersten Leiter 7a des Tragkörpers 2 in Verbindung. In vergleichbarer Weise erfolgt eine Kontaktierung der zweiten Elektroden 13b über die zweiten elektrischen Kontaktmittel 14b an den zweiten elektrischen Leiter 7b.

Die erste Piezoeinheit 5 ist in einer geeigneten Weise an der ersten Tragfläche 4 befestigt. Beim Ausführungsbeispiel geschieht dies durch Verkleben, wobei zwischen der Unterseite der ersten Piezoeinheit 5 und der ersten Tragfläche 4 eine Klebeschicht 15 aufgebracht wird.

Wird über die ersten und zweiten elektrischen Leiter 7a, 7b eine Ansteuerspannung in ausreichender Höhe an die ersten und zweiten Elektroden 13a, 13b angelegt, bilden sich innerhalb der Piezomaterialschichten 12 in der Stapelrichtung 9 polarisierte elektrischer Felder aus, die zur Folge haben, daß sich die in Längsrichtung 16 des Piezo-Biegewandlers 1 gemessenen Längenabmessungen der Piezomaterialschichten 12 verkürzen. Dies hat zur Folge, daß der Piezo-Biegewandler 1 eine Krümmung erfährt, die eine Auslenkung senkrecht zur Biegewandlerlängsrichtung gemäß Pfeil 17 zur Folge hat. Diese Bewegung kann verwendet werden, um eine Antriebs- oder Abdichtfunktion auszuüben.

Im praktischen Einsatz ist der Piezo-Biegewandler 1 rückseitig eingespannt, wobei er mit seinem vorderen Bereich die Auslenkungsbewegung ausführt. Die Einspannung kann am Anschlussabschnitt 6 und/oder in dem sich daran anschließenden rückseitigen Endbereich der ersten Piezoeinheit 5 erfolgen.

Eine bevorzugte Anwendung des Piezo-Biegewandlers 1 ist in Figur 1 strichpunktiert angedeutet. Man erkennt dort schematisch einen Ausschnitt des Gehäuses 18 eines Ventils, das einen Fluidkanal 22 aufweist, der über eine Fluidkanalmündung 23 verfügt, die der vom Tragkörper 2 abgewandten oberen Außenfläche 24a der ersten Piezoeinheit 5 zugewandt ist. Der Piezo-Biegewandler 1 kann nun zur Steuerung einer Fluidströmung verwendet werden, indem er je nach Ansteuerzustand die Fluidkanalmündung 23 freigibt oder verschließt. Der Piezo-Biegewandler 1 übernimmt hier also eine Abdichtfunktion.

Auch andere Anwendungen des Piezo-Biegewandlers sind möglich. Er kann beispielsweise eine Antriebsfunktion übernehmen, wobei er als Stellglied auf ein zu bewegendes Bauteil beliebiger Art einwirkt, wobei es sich wiederum um ein Ventilbauteil handeln kann.

Der Piezokörper 8 könnte an Stelle des abgebildeten Multilayer-Aufbaus auch über einen Singlelayer-Aufbau verfügen, wobei er lediglich eine einzige, entsprechend dicker ausgestaltete Piezomaterialschicht enthält, so daß der Piezowerkstoff einen monolithischen Aufbau hat.

Die erste Piezoeinheit 5 zeichnet sich nun weiter dadurch aus, daß sie einen den Piezokörper 8 ringsum, das heißt komplett umhüllenden, elektrisch isolierenden Überzug 25 aufweist. Sämtliche Piezomaterialschichten 12 und Elektroden 13a, 13b sind somit durch den nach Art einer Hülle aufgebauten Überzug gekapselt und von der Umgebung abgeschottet. Als Resultat ergibt sich eine optimale Abschirmung gegen auftretende Feuchtigkeit oder sonstige Umgebungseinflüsse.

Der Piezokörper 8 der ersten Piezoeinheit 5 hat auch keinen unmittelbaren Kontakt mehr zum Tragkörper 2, der selbst vorzugsweise überzugslos ausgebildet ist. Zur Befestigung am Tragkörper 2 ist die schon erwähnte Klebeschicht 15 zwischen der ersten Tragfläche 4 und der dieser zugewandten unteren Außenfläche 24b des sich zwischen dem Tragkörper 2 und dem Piezokörper 8 erstreckenden unteren Überzugsabschnitt 26 appliziert.

Zur Kontaktierung der ersten und zweiten Elektroden 13a, 13b mit den am Tragkörper 2 vorgesehenen ersten und zweiten elektrischen Leitern 7a, 7b ist die erste Piezoeinheit 5, vorzugsweise im Bereich des unteren Überzugsabschnittes 26, mit dem Überzug 25 durchsetzenden, elektrisch leitenden Durchkontaktierungen 27a, 27b ausgestattet. Sie stehen innerhalb des vom Überzug 25 umschlossenen Raumes zuordnungsrichtig mit den ersten und zweiten Kontaktmitteln 14a, 14b in elektrischer Verbindung und sind außerhalb der ersten Piezoeinheit 5 mit den ersten und zweiten elektrischen Leitern 7a, 7b kontaktiert.

Die ersten und zweiten Durchkontaktierungen 27a, 27b sind so ausgebildet, daß auch in ihrem Bereich eine fluiddichte Abschottung des vom Überzug 25 umgrenzten, den Piezokörper 8 enthaltenden Innenraumes stattfindet. Beim Ausführungsbeispiel wird dies dadurch erreicht, daß man den Überzug 25 im Bereich der Durchkontaktierungen 27a, 27b mit Durchgangsöffnungen 28 versieht, die man mit einem leitfähigen Material, beispielsweise einem Leitkleber oder einem elektrisch leitenden Kunststoffmaterial ausfüllt, wobei das Material eine vorzugsweise stoffschlüssige Verbindung zum Material des Überzuges 25 eingeht.

Da der Überzug 25 aus elektrisch isolierendem Material besteht, wobei vorzugsweise ein dieleketrisches Material verwendet wird, können Kurzschlüsse oder sonstige Beeinträchtigungen vermieden werden und es erübrigen sich insbesondere zusätzliche elektrische Isolationsmaßnahmen bezüglich der vom Überzug 25 überdeckten Bereiche der Elektroden 13a, 13b und elektrischen Kontaktmittel 14a, 14b.

Als besonders zweckmäßig hat sich ein Überzug 25 aus Parylene-Polymerfilm erwiesen (Parylene: Gruppenbezeichnung für thermoplastische Polymerfilme, die aus p-Xylol entstehen). Insbesondere wird sogenanntes Parylene N (unsubstituiertes Poly-Para-Xylylen), Parylene D (Substitution von zwei aromatischen H-Atomen durch zwei Chlor-Atome) oder Parylene C (Substitution eines aromatischen H-Atoms durch ein ChlorAtom) verwendet, wobei sich letzteres aufgrund seiner elektrischen und physikalischen Eigenschaften besonders empfiehlt. Es besitzt vor allem auch eine sehr niedrige Permeabilität bezüglich Feuchtigkeit und anderen korrosiven Gasen. Parylen-Polymere können als strukturell kontinuierliche Schichten mit sehr dünner Schichtdicke ausgeführt werden, so daß die Baugröße des Piezobiegewandlers durch den aufgebrachten Überzug nicht merklich verändert wird.

Alternativ zu einem aus Parylene-Kunststoff bestehenden Parylene-Polymerfilm könnte als Material für den Überzug 25 auch ein Polyimid-Kunststoff verwendet werden, vorzugsweise das von der Firma DuPont vertriebene sogenannte Kapton.

Die Herstellung des Kunststoff-Überzuges 25 kann beispielsweise im Rahmen eines schichtabscheidenden Verfahrens erfolgen.

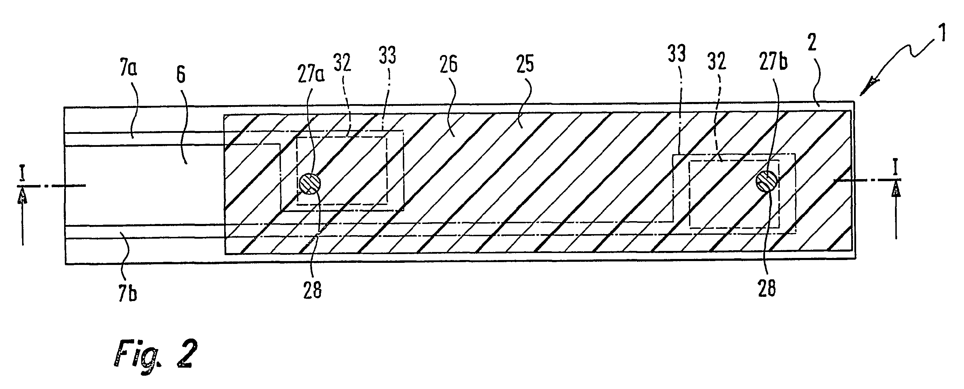

Um den Vorgang des Bestückens des Tragkörpers 2 mit einer Piezoeinheit 5 möglichst wenig anfällig für Herstellungstoleranzen zu halten, ist es von Vorteil, wenn jeder Durchkontaktierung 27a, 27b eine an der dem Tragkörper 2 zugewandten unteren Außenfläche 24b des unteren Überzugsabschnittes 26 vorgesehene Kontaktierungsschicht 32 zugeordnet ist, die mit der betreffenden Durchkontaktierung 27a, 27b verbunden ist, jedoch eine größere Grundfläche als diese aufweist. Die Kontaktierungsschichten 32 sind in Figur 2 durch gestrichelte Linien angedeutet.

In vergleichbarer Weise ist es von Vorteil, wenn die ersten und zweiten elektrischen Leiter 7a, 7b im Bereich einer jeweiligen Durchkontaktierung 27a, 27b eine mit dieser kontaktierte, elektrisch leitende Kontaktfläche 33 aufweisen, die in Figur 2 strichpunktiert angedeutet sind. Ihre Grundfläche kann vorzugsweise größer sein als diejenige der Kontaktierungsschicht 32, so daß die Kontaktierungsschicht 32 vollflächig auf der ihr zugeordneten Kontaktfläche 33 aufliegen kann. Die Kontaktierungsschichten 32 können, wie auch die Kontaktflächen 33 und die gesamten elektrischen Leiter 7a, 7b von einer geeigneten Metallisierung gebildet sein.

Da die erste Piezoeinheit 5 beim Ausführungsbeispiel über zwei Elektrodengruppen 13a, 13b verfügt und für jede Elektrodengruppe eine Durchkontaktierung 27a 27b vorgesehen ist, verfügt die erste Piezoeinheit 5 dementsprechend über eine geringe Anzahl von lediglich zwei Durchkontaktierungen 27a, 27b, die zweckmäßigerweise in der Längsrichtung 16 des Tragkörpers 2 beabstandet zueinander angeordnet sind. Je nach Aufbau der Piezoeinheit könnten auch nur eine einzige oder mehr als zwei Durchkontaktierungen 27 vorgesehen sein.

Der Piezo-Biegewandler 1 des Ausführungsbeispiels verfügt über einen Unimorph-Aufbau mit lediglich einer Piezoeinheit 5. Gleichwohl läßt sich die Erfindung selbstverständlich auch bei einem mehrere Piezoeinheiten besitzenden Piezo-Biegewandler 1 verwenden. Exemplarisch ist in Figur 1 der Aufbau eines Trimorph-Piezo-Biegewandlers angedeutet, wobei der Tragkörper 2 auf der der ersten Tragfläche 4 entgegengesetzten Längsseite über eine zweite Tragfläche 4a verfügt, die mit einer zweiten Piezoeinheit 5a bestückt ist (strichpunktierte Darstellung).

Ein weiterer Vorteil des Piezobiegewandlers 1 besteht darin, daß bei entsprechender Auswahl des Materials für den Überzug 25 auf zusätzliche Bauelemente verzichtet werden kann, um den zu Antriebs- und/oder Abdichtungszwecken erforderlichen Kontakt mit einem Gegenpart auszuführen. Es kann dann die Außenfläche des Überzuges 25 unmittelbar als Beaufschlagungs-und/oder Dichtfläche herangezogen werden, mit der der Piezo-Biegewandler 1 an einem anzutreibenden Bauteil und/oder an einem Ventilsitz anliegt.

## Patentansprüche

1. Piezo-Biegewandler, mit einem länglichen Tragkörper (2), der an wenigstens einer Längsseite mit einer Piezoeinheit (5, 5a) bestückt ist, die einen Piezokörper (8) mit einer oder mehreren Piezomaterialschichten (12) und diesen zugeordneten Elektroden (13a, 13b) aufweist, **dadurch gekennzeichnet, daß** die Piezoeinheit (5, 5b) einen den Piezokörper (8) ringsum umhüllenden, elektrisch isolierenden Überzug (25) aufweist, der mit einer oder mehreren elektrisch leitenden Durchkontaktierungen (27a, 27b) zur elektrischen Kontaktierung der Elektroden (13a, 13b) versehen ist.

2. Piezo-Biegewandler nach Anspruch 1, **dadurch gekennzeichnet, daß** die Durchkontaktierungen (27a, 27b) in dem zwischen dem Piezokörper (8) und dem Tragkörper (2) liegenden Abschnitt (26) des isolierenden Überzugs (25) angeordnet sind und eine elektrisch leitende Verbindung zwischen den Elektroden (13a, 13b) und dem Tragkörper (2) bzw. elektrischen Leitern (7a, 7b) des Tragkörpers (2) herstellen.

3. Piezo-Biegewandler nach Anspruch 2, **dadurch gekennzeichnet, daß** der Tragkörper (2) im Bereich einer jeweiligen Durchkontaktierung (27a, 27b) eine mit dieser kontaktierte, elektrisch leitende Kontaktfläche (33) aufweist.

4. Piezo-Biegewandler nach Anspruch 2 oder 3, **dadurch gekennzeichnet, daß** jeder Durchkontaktierung (27a, 27) eine an der dem Tragkörper (2) zugewandten Außenfläche (24b) des am Tragkörper (2) anliegenden Abschnittes (26) des Überzuges (25) vorgesehene und vorzugsweise als Anschlußpad ausgebildete Kontaktierungsschicht (32) zur Kontaktierung des Tragkörpers (2) zugeordnet ist.

5. Piezo-Biegewandler nach einem der Ansprüche 1 bis 4, **dadurch gekennzeichnet, daß** der Tragkörper (2) einen ein- oder mehrschichtigen Aufbau hat, wobei über elektrische Leiter (7a, 7b) des Tragkörpers (2) die Ansteuerspannung an die Elektroden (13a, 13b) anlegbar ist.

6. Piezo-Biegewandler nach Anspruch 5, **dadurch gekennzeichnet, daß** die elektrischen Leiter (7a, 7b) zumindest teilweise im Inneren des mehrschichtigen Tragkörpers (2) angeordnet sind..

7. Piezo-Biegewandler nach einem der Ansprüche 1 bis 6, **gekennzeichnet, durch** wenigstens zwei in Längsrichtung des Tragkörpers (2) zueinander beabstandete Durchkontaktierungen (27a, 27b).

8. Piezo-Biegewandler nach einem der Ansprüche 1 bis 7, **dadurch gekennzeichnet, daß** der Tragkörper (2) einen Faserverbundkörper umfaßt, der insbesondere aus kohlefaserverstärktem oder glasfaserverstärktem Epoxidharz besteht.

9. Piezo-Biegewandler nach einem der Ansprüche 1 bis 8, **dadurch gekennzeichnet, daß** das Material des Tragkörpers (2) Polyimid umfaßt und insbesondere eine integrierte Elektrodenstruktur aufweist.

10. Piezo-Biegewandler nach einem der Ansprüche 1 bis 9, **dadurch gekennzeichnet, daß** der Piezokörper (8) als Multilayer-Piezokörper ausgeführt ist.

11. Piezo-Biegewandler nach einem der Ansprüche 1 bis 10, **dadurch gekennzeichnet, daß** der Überzug der Piezoeinheit (5, 5a) über dielektrische Materialeigenschaften verfügt.

12. Piezo-Biegewandler nach einem der Ansprüche 1 bis 11,
**dadurch gekennzeichnet, daß** der Überzug aus einem vorzugsweise als Polymerfilm ausgeführten Parylen-Kunststoff besteht, vorzugsweise aus sogenanntem Parylen C.

13. Piezo-Biegewandler nach einem der Ansprüche 1 bis 12, **dadurch gekennzeichnet, daß** der Überzug aus einer Polyimid-Kunststoffschicht besteht, vorzugsweise aus sogenanntem Kapton.

14. Piezo-Biegewandler nach einem der Ansprüche 1 bis 13, **dadurch gekennzeichnet, daß** der Überzug (25) von einer durch ein schichtabscheidendes Verfahren hergestellten Kunststoffschicht gebildet ist.

15. Piezo-Biegewandler nach einem der Ansprüche 1 bis 14, **dadurch gekennzeichnet, daß** eine jeweilige Durchkontaktierung (27a, 27b) aus in eine Durchgangsöffnung (28) des Überzuges (25) eingebrachtem, elektrisch leitfähigem Material besteht, zum Beispiel aus einem Leitkleber.

16. Piezo-Biegewandler nach einem der Ansprüche 1 bis 15, **dadurch gekennzeichnet, daß** der Tragkörper (2) überzugslos ausgebildet ist.

17. Piezo-Biegewandler nach einem der Ansprüche 1 bis 16, **dadurch gekennzeichnet, daß** die Piezoeinheit (5, 5a) mit dem Tragkörper (2) verklebt ist.

18. Piezo-Biegewandler nach einem der Ansprüche 1 bis 17, **dadurch gekennzeichnet, daß** der Tragkörper (2) auf zwei einander entgegengesetzten Längsseiten mit jeweils einer Piezoeinheit (5, 5a) bestückt ist.

19. Verwendung eines Piezo-Biegewandlers nach einem der Ansprüche 1 bis 18 als Stellglied mit Antriebs- und/oder Abdichtfunktion, wobei zweckmäßigerweise die Außenfläche seines Überzuges (25) unmittelbar als Beaufschlagungs- und/oder Dichtfläche herangezogen wird.

## Claims

1. Piezoelectric bending transducer with an elongated support body (2), provided on one or more side walls with a piezoelectric unit (5, 5a) which has a piezoelectric body (8) with one or more piezoelectric material layers (12) and electrodes (13a, 13b) assigned to the latter, **characterised in that** the piezoelectric unit (5, 5b) has an electrically insulating coating (25) which envelops the piezoelectric body (8) all-round and is provided with one or more electrically conductive plated-through holes (27a, 27b) for electrical contacting of the electrodes (13a, 13b).

2. Piezoelectric bending transducer according to claim 1, **characterised in that** the plated-through holes (27a, 27b) are located in the section (26) of the insulating coating (25) lying between the piezoelectric body (8) and the support body (2), and create an electrically conductive connection between the electrodes (13a, 13b) and the support body (2) and electrical conductors (7a, 7b) of the support body (2).

3. Piezoelectric bending transducer according to claim 2, **characterised in that** the support body (2) has, in the area of each plated-through hole (27a, 27b), an electrically conductive contact surface (33) which is contacted by the former.

4. Piezoelectric bending transducer according to claim 2 or 3, **characterised in that** each plated-through hole (27a, 27) is assigned a contacting layer (32) for contacting the support body (2), provided on the outer surface (24b) facing the support body (2) of the section (26) of the coating (25) abutting the support body (2) and preferably in the form of a connecting pad.

5. Piezoelectric bending transducer according to any of claims 1 to 4, **characterised in that** the support body (2) has a single- or multi-layer structure, wherein the drive voltage may be applied to the electrodes (13a, 13b) via electrical conductors (7a, 7b) of the support body (2).

6. Piezoelectric bending transducer according to claim 5, **characterised in that** the electrical conductors (7a, 7b) are located at least partly in the interior of the multi-layer support body (2).

7. Piezoelectric bending transducer according to any of claims 1 to 6, **characterised by** at least two plated-through holes (27a, 27b) spaced apart in the longitudinal direction of the support body (2).

8. Piezoelectric bending transducer according to any of claims 1 to 7, **characterised in that** the support body (2) comprises a fibre-composite body, made in particular of carbon-fibre-reinforced or glass-fibre-reinforced epoxy resin.

9. Piezoelectric bending transducer according to any of claims 1 to 8, **characterised in that** the material of the support body (2) comprises polyamide and has in particular an integrated electrode structure.

10. Piezoelectric bending transducer according to any of claims 1 to 9, **characterised in that** the piezoelectric body (8) is in the form of a multi-layer piezoelectric body.

11. Piezoelectric bending transducer according to any of claims 1 to 10, **characterised in that** the coating of the piezoelectric unit (5, 5a) has dielectric material properties.

12. Piezoelectric bending transducer according to any of claims 1 to 11, **characterised in that** the coating is made of a parylene plastic, preferably in the form of a polymer film and preferably of so-called parylene C.

13. Piezoelectric bending transducer according to any of claims 1 to 12, **characterised in that** the coating is made of a polyimide plastic layer, preferably of so-called Kapton.

14. Piezoelectric bending transducer according to any of claims 1 to 13, **characterised in that** the coating (25) is formed by a plastic layer created by a layer deposition process.

15. Piezoelectric bending transducer according to any of claims 1 to 14, **characterised in that** each plated-through hole (27a, 27b) is made of an electrically conductive material, for example a conductive adhesive, inserted in a through hole (28) of the coating (25).

16. Piezoelectric bending transducer according to any of claims 1 to 15, **characterised in that** the support body (2) is made without a coating.

17. Piezoelectric bending transducer according to any of claims 1 to 16, **characterised in that** the piezoelectric unit (5, 5a) is bonded to the support body (2).

18. Piezoelectric bending transducer according to any of claims 1 to 17, **characterised in that** the support body (2) is equipped with a piezoelectric unit (5, 5a) on each of two opposite side walls.

19. Use of a piezoelectric bending transducer according to any of claims 1 to 18 as a control element with driving and/or sealing function, in which the outer surface of its coating (25) is expediently used directly as the pressure-loading and/or sealing surface.

## Revendications

1. Convertisseur de flexion piézo-électrique, comportant un corps support (2) allongé, qui est équipé sur au moins un grand côté d'une unité piézo-électrique (5, 5a), laquelle présente un corps piézo-électrique (8) avec une ou plusieurs couches de matériau piézo-électrique (12) et des électrodes (1 3a, 1 3b) associées à ces couches, **caractérisé en ce que** l'unité piézo-électrique (5, 5b) présente un revêtement (25) électriquement isolant et entourant tout autour le corps piézo-électrique (8), qui est doté d'une ou plusieurs connexions traversantes (27a, 27b) électroconductrices pour la mise en contact électrique des électrodes (13a, 13b).

2. Convertisseur de flexion piézo-électrique selon la revendication 1, **caractérisé en ce que** les connexions traversantes (27a, 27b) sont disposées dans la partie (26), située entre le corps piézo-électrique (8) et le corps support (2), du revêtement (25) isolant et établissent une liaison électroconductrice entre les électrodes (13a, 13b) et le corps support (2) ou les conducteurs électriques (7a, 7b) du corps support (2).

3. Convertisseur de flexion piézo-électrique selon la revendication 2, **caractérisé en ce que** le corps support (2) présente dans la zone de chaque connexion traversante (27a, 27b) une surface de contact (33) électroconductrice et en contact avec cette connexion.

4. Convertisseur de flexion piézo-électrique selon la revendication 2 ou 3, **caractérisé en ce qu'**à chaque connexion traversante (27a, 27b) est associée une couche d'établissement de contact (32) prévue sur la surface extérieure (24b), tournée vers le corps support (2), de la partie (26) du revêtement (25) s'appuyant sur le corps support (2) et conçue de préférence comme une borne de raccordement pour l'établissement du contact du corps support (2).

5. Convertisseur de flexion piézo-électrique selon l'une des revendications 1 à 4, **caractérisé en ce que** le corps support (2) possède une structure à une couche ou multicouche, la tension d'activation pouvant être appliquée aux électrodes (13a, 13b) par l'intermédiaire de conducteurs électriques (7a, 7b) du corps support (2).

6. Convertisseur de flexion piézo-électrique selon la revendication 5, **caractérisé en ce que** les conducteurs électriques (7a, 7b) sont disposés au moins partiellement à l'intérieur du corps support (2) multicouche.

7. Convertisseur de flexion piézo-électrique selon l'une des revendications 1 à 6, **caractérisé par** au moins deux connexions traversantes (27a, 27b) espacées l'une de l'autre dans le sens longitudinal du corps support (2).

8. Convertisseur de flexion piézo-électrique selon l'une des revendications 1 à 7, **caractérisé en ce que** le corps support (2) comprend un corps renforcé par des fibres, qui est en particulier à base de résine époxy renforcée de fibres de carbone ou renforcée de fibres de verre.

9. Convertisseur de flexion piézo-électrique selon l'une des revendications 1 à 8, **caractérisé en ce que** le matériau du corps support (2) comprend du polyimide et présente en particulier une structure d'électrode intégrée.

10. Convertisseur de flexion piézo-électrique selon l'une des revendications 1 à 9, **caractérisé en ce que** le corps piézo-électrique (8) est conçu comme un corps piézo-électrique multicouche.

11. Convertisseur de flexion piézo-électrique selon l'une des revendications 1 à 10, **caractérisé en ce que** le revêtement de l'unité piézo-électrique (5, 5a) dispose de propriétés de matériau diélectriques.

12. Convertisseur de flexion piézo-électrique selon l'une des revendications 1 à 11, **caractérisé en ce que** le revêtement est en matière plastique à base de parylène, de préférence sous la forme d'un film polymère, de préférence en matière dite de parylène C.

13. Convertisseur de flexion piézo-électrique selon l'une des revendications 1 à 1 2, **caractérisé en ce que** le revêtement est constitué d'une couche de matière plastique à base de polyimide, de préférence à base de matière dite kapton.

14. Convertisseur de flexion piézo-électrique selon l'une des revendications 1 à 13, **caractérisé en ce que** le revêtement (25) est formé par une couche de matière plastique fabriquée par un procédé de précipitation de couche.

15. Convertisseur de flexion piézo-électrique selon l'une quelconque des revendications 1 à 14, **caractérisé en ce que** chaque connexion traversante (27a, 27b) est à base d'un matériau électroconducteur introduit dans une ouverture de passage (28) du revêtement (25), par exemple à base d'une colle conductrice.

16. Convertisseur de flexion piézo-électrique selon l'une des revendications 1 à 15, **caractérisé en ce que** le corps support (2) est conçu sans revêtement.

17. Convertisseur de flexion piézo-électrique selon l'une des revendications 1 à 16, **caractérisé en ce que** l'unité piézo-électrique (5, 5a) est collée sur le corps support (2).

18. Convertisseur de flexion piézo-électrique selon l'une des revendications 1 à 17, **caractérisé en ce que** le corps support (2) est équipé d'une unité piézo-électrique (5, 5a) sur chacun de deux grands côtés qui se font face.

19. Utilisation d'un convertisseur de flexion piézo-électrique selon l'une des revendications 1 à 18 comme actionneur avec fonction d'entraînement et/ou d'étanchéité, la surface extérieure de son revêtement (25) étant utilisée de préférence directement comme surface de sollicitation et/ou surface d'étanchéité.
